# EUROPEAN PATENT APPLICATION

(11) **EP 4 745 972 A2**
(43) Date of publication of application: **20.05.2026**
(21) Application number: 25214783.0
(22) Date of filing: 11.11.2025
(51) Int. Cl.: G11C 29/12, G11C 29/32, G11C 29/00

(54) **BUILT-IN SELF TEST (BIST) FOR A MEMORY WHICH UTILIZES REDUNDANCY REPAIR**

(30) Priority: 15.11.2024 US 202418948895
(71) Applicant: NXP USA, Inc., Austin, TX 78735 (US)
(72) Inventor: ABELN, Glenn Charles, 5656AG Eindhoven (NL); HOEFLER, Alexander, 5656AG Eindhoven (NL); QURESHI, Qadeer, 5656AG Eindhoven (NL); SPRUTH, Henning Fritz, 5656AG Eindhoven (NL)
(74) Representative: Hardingham, Christopher Mark

(57) **Abstract**

A memory includes a data array divided into a plurality of input/output (IO) groups and a redundant IO group, each group including a set of columns. A column decoder selects one column from each IO group to provide selected data lines, and one column from the redundant group to provide a redundant data line. Repair circuitry, during normal operation, performs column repair using the selected one column from the redundant group to repair a defective column within one of the plurality of IO groups. Read/write circuitry, in response to a read access during a test mode, outputs read data sensed from the redundant data line in parallel with read data sensed from all the selected data lines. Control circuitry, in response to the read access during the test mode, provides the output read data sensed from the redundant data line external to the memory via a memory output pin.

## Description

### Background

### Field

This disclosure relates generally to memories, and more specifically, to built-in self test (BIST) for a memory which utilizes redundancy repair.

### Related Art

Memories, such as static random access memories (SRAMs), commonly use redundancy repair. For example, the bit cells of these memories are typically arranged in an array of rows and columns, in which the rows are addressed by corresponding word lines and the columns are addressed by corresponding bit lines. A bit cell with a corresponding storage element is located at the intersection of each row and column. A column or set of columns may be defective, in which case replacement columns can be used to perform column repair upon a read or write access to the memory. These memories typically include a set of redundant columns, in which the redundant columns can be selected and utilized as a replacement column during memory repair.

It is often desirable to test the redundant columns of a repairable memory. However, this testing typically requires two passes for testing the memory, in which a first testing pass through the memory is performed with all redundant columns disabled, and then a second testing pass through the memory is performed with repair enabled so as to test the redundant columns. The need for two testing passes at each testing condition (e.g. at room temperature) consumes additional test time. Therefore, a need exists for improved testing of the redundant columns, which may result in reduced test time.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a memory in accordance with one embodiment of the present invention.
FIGs. 2 and 3 illustrate, in block diagram form, portions of memory control circuitry of the memory of FIG. 1, in accordance with one embodiment of the present invention.

### Detailed Description

In one aspect, a memory (such as an SRAM) includes, as part of its data array, redundant columns which can be used during normal memory operation to replace defective columns in response to read or write accesses which access bit locations from one or more defective columns. Furthermore, circuitry within the memory, such as within a control circuit of the memory, implements one or more scan chains utilized during scan mode, in which each scan chain has an input coupled to a scan input pin of the memory and an output coupled to a scan output pin of the memory such that scan data can be shifted into and out of the scan chains during scan mode. However, when not in scan mode, the scan input and output pins are not typically being utilized. Note that scan mode is typically disabled during normal memory operation as well as during a test mode in which bult-in self test (BIST) is performed.

In one embodiment, repair circuitry within the memory includes a multiplexer (MUX) corresponding to each data line of the data array which is configured to provide access to either the data line or an alternate data line. For example, when memory repair is enabled during normal memory operation, a redundant column can repair a defective column by being multiplexed into an adjacent column (in which the defective column is disabled from communicating with its corresponding data line by its corresponding MUX). However, when not in normal memory operation, such as during a test mode (such as BIST), it is desirable to access the data lines corresponding to the data array of the memory, including those corresponding to the redundant columns of the data array. Therefore, in addition to multiplexing the redundant column to an adjacent column for performing repair during normal memory operation, additional logic is present to access the redundant columns during BIST. In one embodiment, a data line corresponding to the redundant columns is coupled through additional MUXes located at the scan output and input pins, which are used in scan mode but are not in use during BIST. In this manner, when not in scan mode, these additional MUXes enable the data line corresponding to the redundant column to be read or written in parallel with the other data lines of the data array during BIST, thus preventing the need for multiple test passes. Further, these additional MUXes can be controlled by a logical combination of control signals (including, e.g. unused repair or scan control signals) so as to repurpose the scan input and output pins for use by BIST circuitry to test the redundant columns in parallel with the remaining columns of the data array.

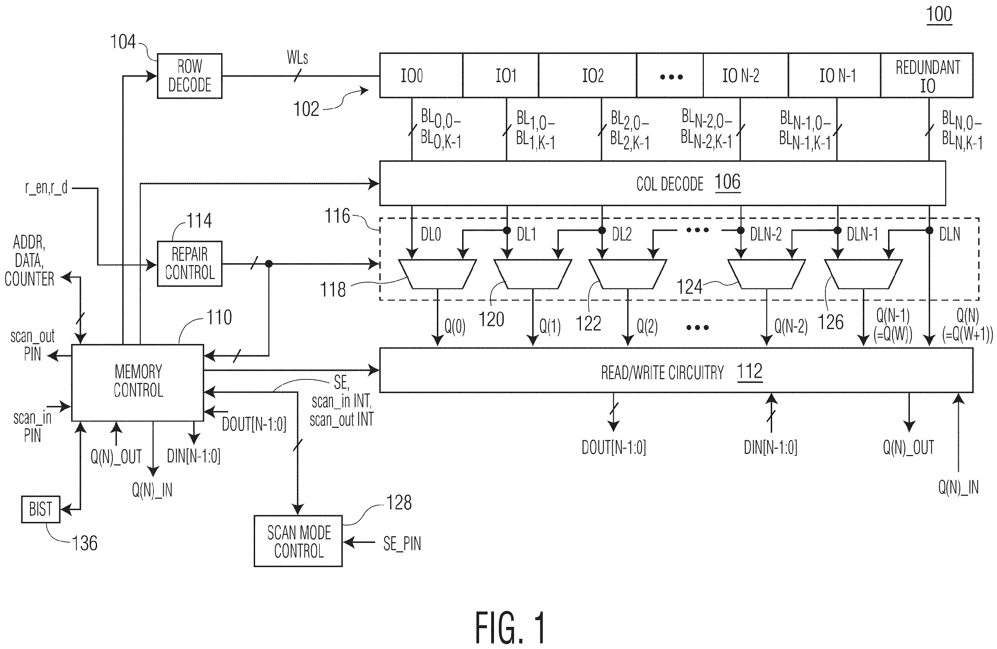

FIG. 1 illustrates, in partial schematic and partial block diagram form, a memory 100 (e.g. an SRAM) which includes a data array 102, a row decoder 104, a column decoder 106, memory control circuitry 110, repair control circuitry 114, repair circuitry 116, read/write circuitry 112, scan mode control circuitry 128, and BIST circuitry 130. Note that BIST circuitry 130 and scan mode control circuit 128 may be located outside memory 100. Memory 100 includes memory pins coupled to memory control circuitry 110 (e.g. a scan_in PIN configured to receive a scan input signal, such as scan chain input data, to a scan chain during scan mode and a scan_out PIN configured to provide a scan output signal, such as scan chain output data, from a scan chain during scan mode). Memory control circuity 110 is also configured to receive a memory access address (ADDR) from a requestor, write data from the requestor when an access request is a write access, and corresponding control signals (CONTROL, such as a read/write (R/W) indicator). Memory control circuitry 110 is also configured to return read data to the requestor when an access is a read access. The write data can be an N-bit input value received as DIN[N-1:0] and the read data can be returned as an N-bit output value provided as DOUT[N-1:0], in which N corresponds to the size of an addressable data element of memory 100. For example, based on the design of memory 100, N can correspond to a word (e.g. 16 bits or 32 bits) or a double word (e.g. 32 bits or 64 bits). For the descriptions herein, it will be assumed that the addressable data element of memory 100 is a word, in which N is 16 bits, such that each read or write access to memory 100 during normal memory operation loads or stores a word (e.g. 16 bits).

Memory control circuitry 110 is also configured to receive a scan enable (SE) signal from scan mode control circuit 128, receive an internal scan input signal (scan_in INT) from scan mode control circuitry 128, and provide an internal scan output signal (scan_out INT) to scan mode control circuitry 128. Memory control circuitry 110 is also configured to communicate with BIST circuitry 130. As will be described in more detail below, during test mode in which BIST is performed, the scan pins (scan_out PIN and scan_in PIN) are unused by memory 100. Therefore, in one embodiment, during scan testing (i.e. when in scan mode), the scan_in and scan_out pins are configured to receive scan_in INT from scan mode control 128 and provide scan_out INT from scan mode control 128, respectively, in which scan_in INT corresponds to an input of a scan chain and scan_out INT corresponds to an output of a scan chain (in which the scan chains are located within memory 100, such as within memory control circuitry 110). However, when not in scan mode but in test mode, scan_in PIN is instead configured to receive input information for use during BIST testing by BIST circuitry 130, and provide output information for use during BIST testing to BIST circuitry 130. Note that each of scan_in PIN, scan_out PIN, scan_in INT, scan_out INT are configured to communicate a single bit of scan chain data, corresponding to a single scan chain of memory 100. However, memory 100 may include any number of scan chains and may therefore include a scan_in PIN, scan_out PIN, scan_in INT, and scan_out INT for each scan chain. Memory 100 may also have visibility to a scan mode pin (SE_PIN) of scan mode control 128, provided as SE to memory control 110, which is used to selectively enable scan mode. When SE_PIN is enabled at a logic level one, SE is also provided as a logic level one to memory control circuitry 110, and the scan_in PIN and scan_out PIN are used for scan testing, but when SE_PIN is disabled at a logic level zero, SE is also a logic level zero and values used during BIST testing can instead be input into and output from these pins.

Referring back to data array 102 of memory 100, data array 102 includes M rows, each having a corresponding word line, WL0 - WLM-1 of WLs, and N input/output (IO) groups, including IO0 - ION-1 and a redundant IO. Each IO group (also referred to as a column group) includes K columns, each column having a corresponding bit line (BL). Therefore, the bit lines are grouped into N-1 groups of K bit lines, resulting in BL_{0,0} - BL_{0,K-1} through BL_{N-1,0} - BL_{N-1,K-1}, in which each BL label is followed by two indices, the first index indicating one of the N groups and the second index indicating one of the K bit lines within the group. For example, BL_{2,0} - BL_{2, K-1} identifies the 3^{rd} group of K bit lines in which, for example, BL_{2,4} refers to the 5^{th} bit line in this 3^{rd} group of K bit lines. Redundant IO also includes K bit lines, labeled as BL_{N,0} - BL_{N,K-1}. A bit cell of data array 102 is located at each intersection of a word line and a bit line. Row decode 104 is coupled to the word lines, and column decode 106 is coupled between the bit lines and read/write circuitry 112. As indicated above, N is assumed to be 16 bits in the embodiments described herein, and, in one embodiment, K=8. However, in alternate embodiments, N and K can be any value. In yet another embodiment, K=1 such that each IO group only includes a single column (i.e. a single bit line).

Control circuitry 110 receives ADDR, CONTROL, and write data for write accesses, and is coupled to both row decode 104 and column decode 106. The access address for a read or write to memory 100 may be referred to herein as a memory access address, in which each access address, during normal operation, accesses N bit cells of array 102 for writing a word of data or reading a word of data. For reads and writes during normal operation, row decode 104 activates one word line (one of the WLs), based on a first portion of a received access address, and column decode 106 selects one bit line from each of the N+1 IO groups of K bit lines to couple to a corresponding data line of DL0 - DLN, based on a second portion of the access address. Note that each of row decode 104 and column decode 106 can be implemented as known in the art. Control circuitry 110 parses the access address and provides the appropriate first portion to row decode 104 and column decode 106, and can provide timing information and any other control signals, as necessary and as known in the art, for performing the writes and reads of array 102. Note that only bit lines are illustrated in FIG. 1, but it is understood that each bit line may also have a corresponding source line, or a complementary bit line, such that each data line at the output of column decode 106 may include only a bit line, only a source line, a bit line/source line pair, or a bit line/complementary bit line pair, depending on the implementation of the read and write circuitries. As used herein, each bit line or source line may be referred to generically as a column line.

Repair circuitry 116 is coupled between DL0-DLN and access data lines Q(0) - Q(N-1), in which, during normal memory operation, the access data lines correspond to an accessed N-bit word (w) location of data array 102. Therefore, Q[N-1:0] is equivalent to Q(w). If repair is not enabled, then Q(w) simply corresponds to DL0 - DLN-1. If repair is enabled, then Q(w) corresponds to N bits of DL0 - DLN (in which DLN is used as a column replacement for one of DL0 - DLN-1, as indicated by repair control circuitry 114). Note that redundant IO provides DLN which corresponds to one bit beyond an N-bit word, such that DLN is provided as Q(N) (also referred to as Q(w+1)). Q(0) - Q(N) are provided to read/write circuitry 112. During normal memory operation, Q(w) (i.e. Q[N-1:0]) corresponds to an accessed N-bit word (w) location in data array 102. For a write access, write data is provided by memory control circuitry 110 as DIN[N-1:0] to read/write circuitry 112 which is then written into data array 102 via Q[N-1:0], and for a read access, read data is sensed on Q[N-1:0] and returned to memory control circuitry 110 as DOUT[N-1:0].

Repair circuitry 116 and corresponding repair control circuitry 114 allow for redundant IO, for a particular access, to replace a defective IO (which can be one of IO0 - ION-1). Repair control circuitry 114 is coupled to memory input pins to receive repair enable signals which indicate whether repair is enabled (r_en) and if so, which columns should be repaired (r_d). In the illustrated embodiment, repair circuitry 116 includes a corresponding MUX (e.g. MUXes 118, 120, 122, 124, and 126) for each of column groups IO0 - ION-1 to receive, at a first input, a corresponding data line from the group (DL0 - DLN-1, respectively). Each corresponding MUX also receives, at a second input, an alternate (i.e. replacement) data line from another column group. In the illustrated embodiment, the alternate data line corresponds to the data line of an immediately neighboring column group such that the corresponding MUXes receive, at the second inputs, DL1 - DLN, respectively. Therefore, in the case that repair is enabled, the data line corresponding to the defective IO group is multiplexed out by repair circuitry 116 while DLN is multiplexed in. Repair control 114 can determine the inputs to the MUXes of repair circuitry 116 and provide control signals to the MUXes of repair circuitry 116 based on the values of r_en and r_d.

For example, in the case in which repair is not enabled (e.g. r_en is negated to a logic level zero), or there are no defective IO groups, DL0 - DLN-1 is connected to Q(0) - Q(N-1) via the corresponding MUXes (e.g. MUXes 118, 120, 122, 124, and 126) in which the control signals of the MUXes are set to a first logic value so as to select the data line from the corresponding group. For example, in this case, the data line from group IO1 (DL1) is selected and connected to Q(1) via MUX 120. If, however, repair is enabled (e.g. r_en is asserted to a logic level one) and IO1 is indicated as defective to repair control circuitry 114 (via r_d), the control signal of the corresponding MUX (e.g. MUX 120) would be set to a second logic value so as to instead select the data line from the neighboring adjacent group (e.g. DL2 of IO2) to be connected to Q(1). The control signal of all MUXes to the right of MUX 118 would similarly be set to the second control value to select the neighboring adjacent group, and in the case of the last IO group (ION-1), MUX 126 would select DLN of the redundant IO to be connected to Q(N-1). In this manner, IO1 (and thus DL1) is multiplexed out and the redundant IO (and thus DLN) is multiplexed in when accessing the accessed data lines Q(0) - Q(N-1). Note that any known circuitry may be used to implement repair circuitry 116 and repair control circuitry 114, in which any known method may be used to multiplex in a redundant IO (or to otherwise replace a defective IO with a redundant IO).

In one embodiment, read/write circuitry 112 includes a set of N+1 sense amplifiers to read (i.e. sense) the data bit values on Q(0) - Q(N). For a read access, read/write circuitry 112 outputs an N-bit read value as DOUT[N-1:0]. The sensed value of Q(N) can be provided, for example, as Q(N)_OUT to memory control 110 Read/write circuitry 112 may include appropriate bit line (and, if needed, source line) drivers coupled to Q(0) - Q(N) to program write data into array 102. For a write access, read/write circuitry 112 can set Q(0) - Q(N-1) based on DIN[N-1:0]. Read/write circuitry 112 may also receive a data value for Q(N) as Q(N)_IN to be programmed into the redundant IO. The read and write circuitries can be implemented as known in the art. In another embodiment, a set of N+1 sense amplifiers may alternatively be located within column decode 106, and provide signals DL0 - DLN at their respective sense amplifier outputs.

Note that memory 100 of FIG. 1 is a simplified memory, having the elements needed to describe embodiments of the present invention, and may therefore include further elements and aspects not illustrated and not pertinent to the embodiments described herein. For example, as mentioned above, data array 102 may also include a source line for each column (corresponding to each bit line) which may also be coupled to column decode 106, in which the source lines, like the bit lines, are coupled to the bit cells of data array 102. The descriptions herein are done with respect to the bit lines of data array 102, but could apply to any column line (bit line or source line). Also, note that the illustrated embodiment of FIG. 1 may only illustrated a portion of data array 102, in which the illustrated portion may be half of one quarter of the full data array. Also, although each read or write access to data array 102 of FIG. 1 accesses an N-bit word, in alternate embodiments, a word may include more or fewer bits, or each access may access more words than just one word.

During normal operation of memory 100, repair control circuitry 114 can either enable or disable repair circuitry 116 based on input r_en. If repair is enabled, repair control circuitry 114 also receives input r_d[x:0] in which r_d may be an x+1 bit signal which identifies which IO group will be repaired (multiplexed out or replaced) by the redundant IO. In addition to normal operation, memory 100 can operate in scan mode in which scan testing is performing using scan chains within memory 100, and memory 100 may also operate in test mode during which BIST is performed. Therefore, memory 100 is capable of operating in at least three different exclusive modes: normal mode (corresponding to normal functional operation, with our without redundancy enabled), scan mode (corresponding to scan testing with or without redundancy enabled), and test mode (corresponding to BIST). Each of these modes is exclusive to the other modes, in that memory 100 can only operate in one of these modes at a time.

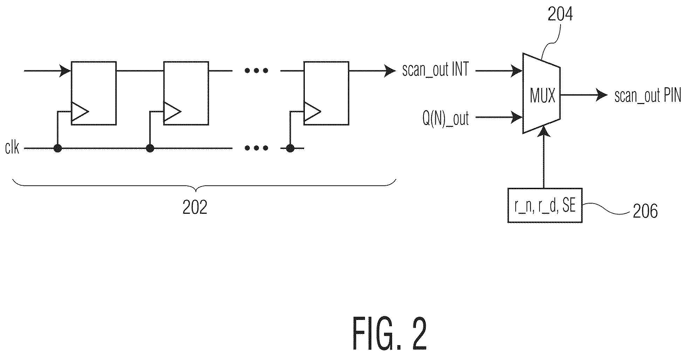

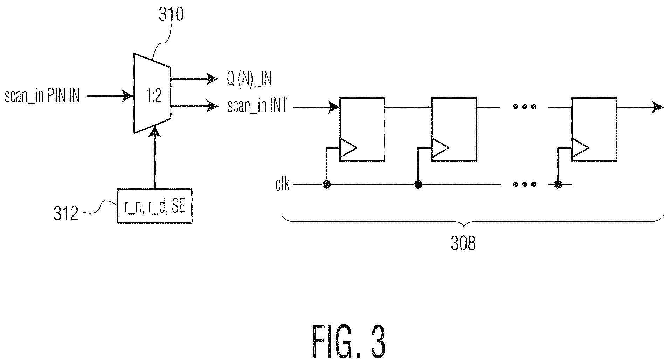

Note that during memory operation in which reads and writes of data array 102 are being performed, only a total of N bits is accessed. That is, only an addressable data element (e.g. Q(w)) is accessed. Therefore, in the case of redundancy being disabled or no repair of a defective column is needed, the data line of the redundant IO group (DLN), corresponding to Q(w+1), is not accessed from outside memory 100. However, in order to more completely perform BIST testing on data array 102 during the test mode, the data of the redundant data line (corresponding to Q(N)_OUT) is MUXed with scan_out INT onto scan_out PIN to be able to read Q(w+1) in parallel with all the bits of Q(w). This will be described in more detail with respect to FIG. 2 below. Similarly, an extra bit can be provided to scan_in PIN, via a 1:2 decoder, as Q(N)_IN to Q(w+1) to be written in parallel with all the bits of Q(w). This will be described in more detail with respect to FIG. 3 below. In each of these cases, control signals available during scan testing or repair can be reused during BIST testing to control how to properly route signals to and from the scan pins, depending on whether normal operation is occurring (normal reads and writes, which may or may not utilize repair) or BIST testing. By being able to access Q(w+1) in addition to Q(w), BIST testing is performed with parallel redundancy which is capable of testing all IO groups of data array 102, including the redundant IO, without requiring multiple testing passes.

The table below provides an example of how various control signals are used during operation of memory 100 in its various modes. A first control signal corresponds to r_en and is used to selectively enable redundancy (i.e. column repair), in which a value of one indicates that repair is enabled and a zero indicates that repair is not enabled. A second control signal corresponds to r_d[x:0] which controls which IO will be repaired out (in which the second control signal can be just a single bit of r_d or, alternatively, can be more than one bit of r_d). A third control signal corresponds to SE (provided by SE_PIN of scan mode control circuitry 128), in which a value of one enables scan mode and a value of zero indicates scan mode is not enabled.

| **r_en** | **r_d[x:0]** | **SE** | **Mode** |
|---|---|---|---|
| 0 | 0 | 0 | Normal functional operation, without redundancy enabled |
| 0 | x | 1 | Scan mode, without redundancy enabled |
| 0 | 1 | 0 | BIST test mode with parallel redundancy for Q(w+1) |
| 1 | x | 0 | Normal functional operation, with redundancy enabled |
| 1 | x | 1 | Scan mode, with redundancy enabled |

Therefore, as will be seen in FIGs. 2 and 3 below, existing scan pins and repair pins can be used to select the test mode which implements BIST with parallel redundancy (also referred to as "parallel redundancy test mode") in which a parallel read or write of Q(w+1) along with Q(w) is enabled. This is possible because the scan chains are not used during test mode. Therefore, SoC 100 or BIST 136 can set r_en to 0, r_d[x:0] to 1, and SE to 0 in order to allow BIST test mode with parallel redundancy. Note that setting r_d[x:0] to1 indicates that not all bus pins of r_d[x:0] are low (i.e. 0).

FIG. 2 illustrates, in block diagram form, an example scan chain 202 which may be located within memory 100, such as within memory control circuitry 110. Scan chain 202 includes multiple flip flops (FFs) which can be configured to either operate functionally or to be coupled in series for inputting and outputting scan chains. Scan testing is known in the art, therefore, further details in setting up the scan chains and performing scan testing will not be described herein. Note also that memory 100 may include any number of scan chains. An output of scan chain 202 (from the last FF of the scan chain) is provided as scan_out INT such that scan chain output data can be serially output from scan chain 202 via scan_out INT. The scan chain output, scan_out INT, is provided as a first input to a MUX 204 (which may be located within memory control circuitry 110), and Q(N)_OUT is provided as a second input to MUX 204. A control signal is provided as a first logical combination 206 of r_en, r_d, and SE. In one embodiment, logical combination 206 refers to "(NOT r_en) AND r_d AND (NOT SE)." When scan mode is enabled, "NOT SE" is a logic level zero, causing logical combination 206 to evaluate as a zero, thus selecting scan_out INT to be output via scan_out PIN, as is typically the case during scan mode for scan testing. However, when scan mode is not enabled, but BIST mode is instead enabled (r_en is a logic level zero and r_d is a logic level one), then logical combination 206 evaluates as a logic level one, thus selecting Q(w+1) to be output via scan_out PIN. In this manner, Q(w+1) from the redundancy IO group is provided visibility via a scan pin as Q(N)_OUT while Q(w) is provided as DOUT[N-1:0]. Therefore, scan_out PIN is selectable between a scan output and redundancy IO output, based on a logical combination of control signals.

FIG. 3 illustrates, in block diagram form, an example scan chain 308 which may be located within memory 100, such as within memory control circuitry 110. Scan chain 308 may be the same scan chain as scan chain 202 or may be a different scan chain of memory 100. A first FF of scan chain 308 receives a scan chain input, scan_in INT, configured to serially receive scan chain input data. A 1:2 decoder 310 has an input coupled to scan_in PIN, in which, based on a control signal which is provided as a logical combination 312 of r_en, r_d, and SE, provides the input received at scan_in PIN as either Q(N)_IN to Q(w+1) or as scan_in INT. In one embodiment, logical combination 312 refers to "(NOT r_en) AND r_d AND (NOT SE)." When scan mode is enabled, "NOT SE" is a logic level zero, causing logical combination 312 to evaluate as a zero, thus routing scan_in PIN to scan_in INT, as is typically the case for scan mode. However, when scan mode is not enabled, but BIST mode is enabled (r_en is a logic level zero and r_d is a logic level one), then logical combination 312 evaluates as a logic level one, thus routing scan_in PIN as Q(N)_IN to Q(w+1) while DIN[N-1:0] is provided to Q(w). In this manner, Q(w+1) can be written into the redundancy IO group in parallel with Q(w). Therefore, scan_in PIN can be used to either provide a scan input or a redundancy data bit input, based on a logical combination of control signals.

Therefore, by now it can be appreciated how different pins may be reconfigured, when not needed, to allow improved visibility to a redundant IO group for improved BIST. This improved visibility allows redundant IOs to be tested in one pass, in parallel with the other IO groups of a data array. This improved visibility is achieved by leveraging other control signals, in addition to various pins, which are only used in mutually exclusive modes of operation. For example, since BIST is performed while in test mode, control signals and pins related to scan mode can be reused during BIST testing to output data from the redundant IO or write data into the redundant IO in parallel with accessing the other IO groups of the data array.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different architectures in a variety of different information processing systems. For example, although FIG. 1 and the discussion thereof describe an exemplary memory system architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of system 100 are circuitry located on a single integrated circuit or within a same device. Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, the data array in the memory of FIG. 1 can include any number of redundant column groups to repair any number of defective columns. Similarly, memory 100 may include other scan pins which may be reconfigured for use during test mode for improved BIST. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, a memory includes an output pin; a data array having a plurality of rows and columns, wherein a memory cell is located at an intersection of each row and column, wherein the data array is divided into a plurality of input/output (IO) groups and a redundant IO group, each group including a set of columns; a column decoder configured to select one column from each IO group of the plurality of IO groups to provide selected data lines from the data array and one column from the redundant group to provide a redundant data line from the data array; repair circuitry configured to, during normal operation, perform column repair using the selected one column from the redundant group to repair a defective column within one of the plurality of IO groups; read/write circuitry configured to, in response to a read access during a test mode in which built-in self-testing (BIST) is performed, output read data sensed from the redundant data line in parallel with read data sensed from all the selected data lines; and memory control circuitry configured to, in response to the read access during the test mode, provide the output read data sensed from the redundant data line external to the memory via the output pin. In one aspect, the repair circuitry is further configured to, during the test mode, couple all the selected data lines to the read/write circuitry. In a further aspect, the repair circuitry is further configured to, for a read access during normal operation, select a set of N data lines from the selected data lines and the redundant data line to couple to the read/write circuitry, wherein N corresponds to a number of bits in an addressable data element of the data array for the read access. In yet a further aspect, for the read access during normal operation, an unselected data line outside the selected set of N data lines corresponds to a defective column repaired with the selected one column from the redundant IO group. In another further aspect, the read data sensed from the redundant data line in parallel with read data sensed from the selected data lines includes N+1 data bits. In another aspect of the above embodiment, the memory control circuitry includes a plurality of flip flops configured as a scan chain, the scan chain having an output configured to serially output scan chain output data, wherein, during a scan mode of the memory, which is mutually exclusive with the test mode and with normal operation, the memory control circuitry is configured to provide the scan chain output data external to the memory via the output pin. In a further aspect, the memory control circuitry includes a multiplexer (MUX) having a first input configured to receive the scan chain output data, a second input configured to receive the output read data sensed from the redundant data line, and an output coupled to the output pin, wherein the MUX is configured to provide the scan chain output data to the output pin during the scan mode and provide the output read data sensed from the redundant data line to the output pin during the test mode. In yet a further aspect, the MUX further includes a control input coupled to receive a logical combination of a set of control signals used by the memory during at least one of the scan mode or normal operation with column repair. In yet an even further aspect, the set of control signals includes a scan enable signal which selectively enables scan mode, a repair enable signal which selectively enables column repair, and one or more bits of a defective column indicator which indicates a defective column of the plurality of IO groups which is to be repaired when column repair is enabled. In yet another aspect of the above embodiment, the memory further includes an input pin, and the memory control circuitry includes a plurality of flip flops configured as a scan chain, the scan chain having an input configured to serially receive scan chain input data, wherein, during a scan mode of the memory, which is mutually exclusive with the test mode and with normal operation, the memory control circuitry is configured to receive the scan chain input data via the input pin. In a further aspect, the memory control circuitry includes a one-to-two (1:2) decoder having an input coupled to the input pin to receive an input bit, a first output configured to provide the input bit to the read/write circuitry for a write access during normal operation, a second output configured to provide the input bit to the input of the scan chain during the scan mode, and a control input coupled to a receive a logical combination of a set of control signals. In yet a further aspect, the set of control signals includes a scan enable signal which selectively enables scan mode, a repair enable signal which selectively enables column repair, and one or more bits of a defective column indicator which indicates a defective column of the plurality of IO groups which is to be repaired when column repair is enabled. In another further aspect, in response to the write access during normal operation, the input bit is stored into the redundant IO in parallel with storing write data of the write access into the plurality of IO groups. In yet another aspect of the above embodiment, the repair circuitry includes a plurality of multiplexers (MUXes), each coupled to receive a data line from a corresponding IO group of the plurality of IO groups, wherein each MUX of the plurality of MUXes is configured to, during normal operation, provide one of the data line from the corresponding IO group or an alternate data line to the read/write circuitry. In a further aspect, the alternate data line of each MUX is one of a data line corresponding to a neighboring IO group or the redundant data line.

In another embodiment, a memory includes a plurality of flip flops configured as a scan chain having a scan input configured to serially receive scan chain input data and a scan output configured to serially output scan chain output data during a scan mode of the memory; a scan output pin configured to provide the scan chain output data from the scan output of the scan chain during the scan mode; a data array having a plurality of rows and columns, wherein a memory cell is located at an intersection of each row and column, wherein the data array is divided into a plurality of input/output (IO) groups and a redundant IO group, each group including a set of columns; a column decoder configured to select one column from each IO group of the plurality of IO groups to provide selected data lines and one column from the redundant group to provide a redundant data line; read/write circuitry configured to, in response to a read access during a test mode in which built-in self-testing (BIST) is performed, output read data sensed from the redundant data line in parallel with read data sensed from all the selected data lines, wherein the scan mode and test mode are mutually exclusive; and memory control circuitry configured to, in response to the read access during the test mode, provide the output read data sensed from the redundant data line external to the memory via the scan output pin. In one aspect of the another embodiment, the memory further includes repair circuitry configured to, during normal operation, perform column repair using the selected one column from the redundant group to repair a defective column within one of the plurality of IO groups, wherein the scan mode and test modes occur outside of normal operation, wherein the memory control circuitry includes a multiplexer (MUX) having a first input coupled to the scan output to receive the scan chain output data, a second input coupled to the read/write circuitry to receive the output read data sensed from the redundant data line, and an output coupled to the scan output pin. In a further aspect, the memory further includes a scan input pin, wherein the memory control circuitry includes a one-to-two (1:2) decoder having an input coupled to the scan input pin to receive an input bit, a first output configured to provide the input bit to the read/write circuitry for a write access during normal operation, and a second output configured to provide the input bit to the scan input of the scan chain during the scan mode. In yet a further aspect, the MUX further includes a control input coupled to receive a first logical combination of a set of control signals, and the one-to-two decoder further includes a control input coupled to receive a second logical combination of the set of control signals. In yet an even further aspect, the set of control signals includes a scan enable signal which selectively enables scan mode, a repair enable signal which selectively enables column repair, and one or more bits of a defective column indicator which indicates a defective column of the plurality of IO groups which is to be repaired when column repair is enabled.

## Claims

1. A memory, comprising:
an output pin;
a data array having a plurality of rows and columns, wherein a memory cell is located at an intersection of each row and column, wherein the data array is divided into a plurality of input/output, IO, groups and a redundant IO group, each group including a set of columns;
a column decoder configured to select one column from each IO group of the plurality of IO groups to provide selected data lines from the data array and one column from the redundant group to provide a redundant data line from the data array;
repair circuitry configured to, during normal operation, perform column repair using the selected one column from the redundant group to repair a defective column within one of the plurality of IO groups;
read/write circuitry configured to, in response to a read access during a test mode in which built-in self-testing (BIST) is performed, output read data sensed from the redundant data line in parallel with read data sensed from all the selected data lines; and
memory control circuitry configured to, in response to the read access during the test mode, provide the output read data sensed from the redundant data line external to the memory via the output pin.

2. The memory of claim 1, wherein the repair circuitry is further configured to, during the test mode, couple all the selected data lines to the read/write circuitry.

3. The memory of claim 2, wherein the repair circuitry is further configured to, for a read access during normal operation, select a set of N data lines from the selected data lines and the redundant data line to couple to the read/write circuitry, wherein N corresponds to a number of bits in an addressable data element of the data array for the read access.

4. The memory of claim 3, wherein, for the read access during normal operation, an unselected data line outside the selected set of N data lines corresponds to a defective column repaired with the selected one column from the redundant IO group.

5. The memory of claim 3 or 4, wherein the read data sensed from the redundant data line in parallel with read data sensed from the selected data lines includes N+1 data bits.

6. The memory of any preceding claim, wherein the memory control circuitry comprises:
a plurality of flip flops configured as a scan chain, the scan chain having an output configured to serially output scan chain output data, wherein, during a scan mode of the memory, which is mutually exclusive with the test mode and with normal operation, the memory control circuitry is configured to provide the scan chain output data external to the memory via the output pin.

7. The memory of claim 6, wherein the memory control circuitry comprises:
a multiplexer (MUX) having a first input configured to receive the scan chain output data, a second input configured to receive the output read data sensed from the redundant data line, and an output coupled to the output pin, wherein the MUX is configured to provide the scan chain output data to the output pin during the scan mode and provide the output read data sensed from the redundant data line to the output pin during the test mode.

8. The memory of claim 7, wherein the MUX further comprises a control input coupled to receive a logical combination of a set of control signals used by the memory during at least one of the scan mode or normal operation with column repair.

9. The memory of claim 8, wherein the set of control signals includes a scan enable signal which selectively enables scan mode, a repair enable signal which selectively enables column repair, and one or more bits of a defective column indicator which indicates a defective column of the plurality of IO groups which is to be repaired when column repair is enabled.

10. The memory of any preceding claim, wherein the memory further comprises an input pin, and the memory control circuitry comprises:
a plurality of flip flops configured as a scan chain, the scan chain having an input configured to serially receive scan chain input data, wherein, during a scan mode of the memory, which is mutually exclusive with the test mode and with normal operation, the memory control circuitry is configured to receive the scan chain input data via the input pin.

11. The memory of claim 10, wherein the memory control circuitry comprises:
a one-to-two (1:2) decoder having an input coupled to the input pin to receive an input bit, a first output configured to provide the input bit to the read/write circuitry for a write access during normal operation, a second output configured to provide the input bit to the input of the scan chain during the scan mode, and a control input coupled to a receive a logical combination of a set of control signals.

12. The memory of claim 11, wherein the set of control signals includes a scan enable signal which selectively enables scan mode, a repair enable signal which selectively enables column repair, and one or more bits of a defective column indicator which indicates a defective column of the plurality of IO groups which is to be repaired when column repair is enabled.

13. The memory of claim 11 or 12, wherein, in response to the write access during normal operation, the input bit is stored into the redundant IO in parallel with storing write data of the write access into the plurality of IO groups.

14. The memory of any preceding claim, wherein the repair circuitry comprises a plurality of multiplexers, MUXes, each coupled to receive a data line from a corresponding IO group of the plurality of IO groups, wherein each MUX of the plurality of MUXes is configured to, during normal operation, provide one of the data line from the corresponding IO group or an alternate data line to the read/write circuitry.

15. The memory of claim 14, wherein the alternate data line of each MUX is one of a data line corresponding to a neighboring IO group or the redundant data line.
